# EUROPEAN PATENT APPLICATION

(11) **EP 3 324 441 A1**
(43) Date of publication of application: **23.05.2018**
(21) Application number: 17202045.5
(22) Date of filing: 16.11.2017
(51) Int. Cl.: H01L 29/49, H01L 29/66, H01L 29/78

(54) **SEMICONDUCTOR STRUCTURES AND FABRICATION METHODS THEREOF**

(30) Priority: 17.11.2016 CN 201611013353
(71) Applicant: Semiconductor Manufacturing International Corporation (Shanghai), Shanghai 201203 (CN); Semiconductor Manufacturing International Corporation (Beijing), Beijing 100176 (CN)
(72) Inventor: XU, Jianhua, Shanghai, 201203 (CN)
(74) Representative: Klunker IP Patentanwälte PartG mbB

(57) **Abstract**

A method for fabricating a semiconductor structure includes providing a base structure, forming a dielectric layer on the base structure, forming a plurality of openings in the dielectric layer, forming a gate dielectric layer on bottom and sidewall surfaces of each opening, and forming an aluminum-containing work function layer on the gate dielectric layer in each opening. Along the direction from the gate dielectric layer to the top of the opening, the atomic concentration of aluminum atoms in the aluminum-containing work function layer decreases. The method further includes forming a metal layer on the aluminum-containing work function layer to fill each opening. The metal layer, the aluminum-containing work function layer, and the gate dielectric layer together form a gate structure.

## Description

### CROSS-REFERENCES TO RELATED APPLICATIONS

This application claims the priority of Chinese Patent Application No. CN201611013353.0, filed on November 17, 2016.

### TECHNICAL FIELD

The present invention generally relates to the field of semiconductor fabrication technology and, more particularly, relates to semiconductor structures and fabrication methods thereof.

### BACKGROUND

The semiconductor devices for integrated circuits (ICs), especially for very-large scale integrated (VLSI) circuits, include metal-oxide-semiconductor field-effect transistors (MOSFETs). With the continuous development of IC manufacturing technology, the technical nodes of semiconductor devices continue to decrease, and the geometrical dimensions of semiconductor devices become smaller and smaller following the Moore's law. When the reduction of the dimensions of semiconductor devices reaches a certain level, various secondary effects, due to the physical limits of semiconductor devices, begin to emerge, and thus further scaling down the feature size of semiconductor devices becomes more and more difficult. Among all the problems in the field of semiconductor manufacturing, the most challenging one is to solve the large leakage current issue in semiconductor devices. Specifically, a large leakage current in a semiconductor device is mainly caused by the continuous decrease in the thickness of the dielectric layer in the semiconductor devices.

Currently, a method to solve the problem includes use of a high-k material to replace the conventionally-used SiO₂ as the gate dielectric material and also includes use of a metal material as the gate electrode material to avoid Fermi level pinning between the high-k material and the conventional gate electrode material and also avoid boron penetration. Such a gate structure using a high-k material to form the gate dielectric layer and a metal material to form the gate electrode is known as a high-k metal gate (HKMG). The introduction of HKMG reduces the leakage current in semiconductor structures.

However, even after introducing HKMGs into semiconductor structures, there are many unsolved problems. One of the challenges is to match the work function because the work function directly affects the threshold voltage (Vₜ) and the performance of the transistor. Specifically, the work function needs to be adjusted to a proper operation range for the semiconductor device.

According to the current technology, the adjustment of the threshold voltage of a transistor is achieved by forming a work function layer in the gate structure of the transistor. However, the electrical properties of a transistor incorporating a work function layer according to the current technology may still need to be improved.

### BRIEF SUMMARY

It is an object of the present invention to provide a semiconductor structure and a method for fabricating a semiconductor structure which may solve one or more problems set forth above and other problems in the art, in particular which may achieve improved electrical properties of a transistor incorporating a work function layer.

The object is achieved by the features of the respective independent claims. Further embodiments are defined in the respective dependent claims.

A first aspect of the present invention provides a method for fabricating a semiconductor structure. The method includes providing a base structure, forming a dielectric layer on the base structure, forming a plurality of openings in the dielectric layer, forming a gate dielectric layer on bottom and sidewall surfaces of each opening, and forming an aluminum-containing work function layer on the gate dielectric layer in each opening. Along the direction from the gate dielectric layer to the top of the opening, the atomic concentration of aluminum atoms in the aluminum-containing work function layer decreases. The method further includes forming a metal layer on the aluminum-containing work function layer to fill each opening. The metal layer, the aluminum-containing work function layer, and the gate dielectric layer together form a gate structure.

Preferably, the atomic concentration of the aluminum atoms in the aluminum-containing work function layer is in a range of approximately 40% to 75% by a total number of atoms in the aluminum-containing work function layer.

Preferably, an average atomic concentration of the aluminum atoms is in a range of approximately 60% to 70% by a total number of atoms in the aluminum-containing work function layer.

Preferably, the aluminum-containing work function layer is made of at least one of TiAl, TaAl, TiAlC, TaAlN, TiAlN, and AlN.

Preferably, a thickness of the aluminum-containing work function layer is in a range of approximately 30 Å to 70 Å.

Preferably, the aluminum-containing work function layer is formed by an atomic layer deposition process.

Preferably, forming the aluminum-containing work function layer includes: at least one deposition of an aluminum-containing material, each deposition including: introducing an aluminum-containing precursor, and removing the aluminum-containing precursor.

Preferably, the aluminum-containing precursor is one of (C2H5)3Al and AlCH3.

Preferably, forming the aluminum-containing work function layer includes: performing multiple times of deposition of the aluminum-containing material, wherein: a pulse time for introducing the aluminum-containing precursor in each deposition gradually decreases, as the multiple times of deposition of the aluminum-containing material are performed.

Preferably, the pulse time for introducing the aluminum-containing precursor in each deposition is in a range of approximately 8 seconds to 25 seconds.

Preferably, forming the aluminum-containing work function layer includes: performing multiple times of deposition of the aluminum-containing material, wherein: a flow rate for introducing the aluminum-containing precursor in each deposition gradually decreases, as the multiple times of deposition of the aluminum-containing material are performed.

Preferably, the flow rate for introducing the aluminum-containing precursor in each deposition is in a range of approximately 200 sccm to 600 sccm.

Preferably, the semiconductor structure is a fin field-effect-transistor device, and wherein: in the process of providing the base structure, the base structure includes a substrate and a plurality of fin structures formed on the substrate; in the process of forming the plurality of openings, a bottom of each opening exposes a portion of top and sidewall surfaces of a fin structure; and in the process of forming the gate dielectric layer, the aluminum-containing work function layer, and the metal layer, the gate dielectric layer, the aluminum-containing work function layer, and the metal layer are sequentially formed on a portion of the fin structure exposed in the opening and also on the sidewalls of the opening.

A second aspect of the present invention provides a semiconductor structure. The semiconductor structure includes a base structure, a dielectric layer formed on the base structure, and a plurality of gate structures. Each gate structure includes a metal layer formed within the dielectric layer, and an aluminum-containing work function layer together with a gate dielectric layer, formed between the dielectric layer and the metal layer, and between the metal layer and the base structure. The aluminum-containing work function layer is formed between the metal layer and the gate dielectric layer. Along the direction from the gate dielectric layer to the metal layer, the atomic concentration of aluminum atoms in the aluminum-containing work function layer decreases.

Preferably, he atomic concentration of the aluminum atoms in the aluminum-containing work function layer is in a range of approximately 40% to 75% by a total number of atoms in the aluminum-containing work function layer.

Preferably, an average atomic concentration of the aluminum atoms is in a range of approximately 60% to 70% by a total number of atoms in the aluminum-containing work function layer.

Preferably, the aluminum-containing work function layer is made of at least one of TiAl, TaAl, TiAlC, TaAlN, TiAlN, and AlN.

Preferably, a thickness of the aluminum-containing work function layer is in a range of approximately 30 Å to 70 Å.

Preferably, the semiconductor structure is a fin field-effect-transistor device, and wherein: the base structure includes a substrate and a plurality of fin structures formed on the substrate; and the plurality of gate structures are formed across the fin structures and cover a portion of top and sidewall surfaces of the fin structures.

Preferably, the semiconductor structure further includes: an interfacial layer formed between the base structure and each gate dielectric layer.

A semiconductor structure according to the second aspect of the present invention may be obtained by a method according to the first aspect of the present invention.

Other aspects of the present invention can be understood by those skilled in the art in light of the description, the claims, and the drawings of the present invention.

### BRIEF DESCRIPTION OF THE DRAWINGS

The following drawings are merely examples for illustrative purposes according to various disclosed embodiments and are not intended to limit the present invention.
FIG. 1 illustrates a schematic cross-section view of a transistor containing a work function layer;
FIG. 2 illustrates a schematic diagram of a correlation between a dimension of a gate structure and a threshold voltage of a corresponding transistor;
FIGS. 3-9 illustrate schematic views of semiconductor structures at certain stages of an exemplary fabrication process for a semiconductor structure consistent with various disclosed embodiments in the present invention; and
FIG. 10 illustrates a flowchart of an exemplary method for fabricating a semiconductor structure consistent with various disclosed embodiments in the present invention.

### DETAILED DESCRIPTION

Reference will now be made in detail to exemplary embodiments of the invention, which are illustrated in the accompanying drawings. Wherever possible, the same reference numbers will be used throughout the drawings to refer to the same or like parts.

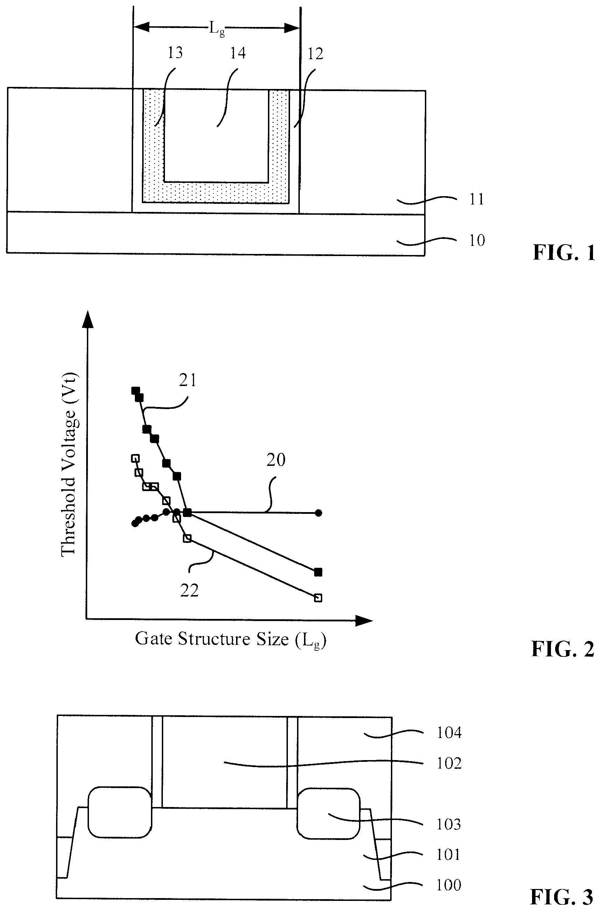

FIG. 1 illustrates a schematic cross-section view of a transistor containing a work function layer. Referring to FIG. 1, the transistor includes a substrate 10 and a dielectric layer 11 formed on the substrate 10. An opening (not shown) is formed in the dielectric layer with the bottom of the opening exposing a portion of the surface of the substrate 10. The transistor further includes a gate structure formed in the opening. The gate structure includes a gate dielectric layer 12 formed on the bottom and the sidewall surfaces of the opening, a work function layer 13 formed on the gate dielectric layer 12, and a metal layer 14 formed on the work function layer 13 and filling up the opening.

The work function layer 13 is an Al-containing work function layer. That is, the work function layer 13 is made of a metal material containing Al. For example, the work function layer 13 may be made of one or more of TiAl, TaAl, TiAlC, TaAlN, TiAlN, AlN, etc.

With the continuous development of the IC manufacturing technology, the feature size of ICs continuously decreases. In order to accommodate the reduction of the feature size, the channel length of the transistors is also shortened, and accordingly, the dimension of the gate structure is reduced. Therefore, as shown in FIG. 1, during the fabrication process of the transistor, the dimension of the opening, L_{g}, decreases and the aspect ratio of the opening increases.

Further, during the process to form the gate structure, in order to improve the step coverage of the formed work function layer 13, an atomic layer deposition process is usually used to form the work function layer 13. When the work function layer 13 is an Al-containing work function layer, because the molecule volume of the Al-containing precursor used to form the Al-containing work function layer is relatively large, the increase in the aspect ratio of the opening may make it difficult for the Al-containing precursor to enter the opening, resulting in poor deposition of Al atoms in the opening. As such, the deposition loading effect may take place.

Further, the deposition loading effect of Al atoms may cause increased difficulties for forming the work function layer 13, and thus the thickness of the formed work function layer 13 may be too small or the atomic concentration of the Al atoms may be too low.

The atomic concentration of the Al atoms in the work function layer 13 refers to the ratio of the number of the Al atoms in the work function layer 13 over the total number of atoms in the work function layer 13.

The atomic concentration of the Al atoms in the Al-containing work function layer may be inversely proportional to the work function value of the Al-containing work function layer, and the thickness of the work function layer may also be inversely proportional to the work function value of the work function layer. Therefore, when the thickness of the work function layer 13 is too small or the atomic concentration of the Al atoms is too low, the work function value of the work function layer 13 may be overly large, which can easily lead to the threshold voltage roll-up issue.

FIG. 2 illustrates a schematic diagram of the correlation between the dimension of a gate structure and the threshold voltage of the corresponding transistor. Referring to FIG. 2, the horizontal axis represents the dimension of the gate structure and the vertical axis represents the threshold voltage of the transistor corresponding to the gate structure. Curve 20 in the figure represents the target threshold voltage of the formed transistor, Curve 21 represents the threshold voltage of the transistor formed under a first process condition, and Curve 22 represents the threshold voltage of the transistor formed under a second process condition.

As shown in FIG. 2, regardless whether the transistor is formed under the first process condition represented by curve 21 or formed under the second process condition represented by curve 22, as long as the dimension of the gate structure L_{g} is smaller, the threshold voltage Vₜ of the formed transistor is larger. Moreover, as the dimension of the gate structure L_{g} decreases, the increase in the threshold voltage Vₜ of the transistor becomes more prominent.

The threshold voltage roll-up issue in a transistor is detrimental to reducing the threshold voltage of the formed transistor, and thus may further affect the performance of the formed semiconductor structure.

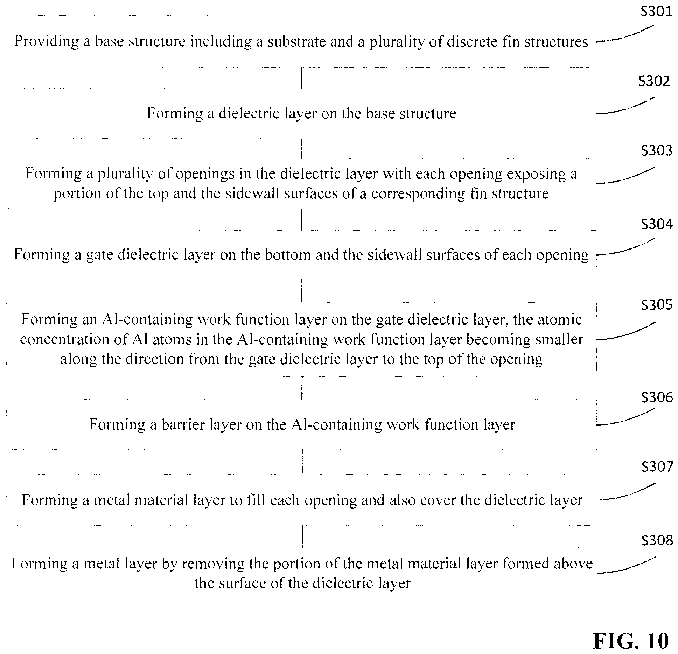

The present invention provides semiconductor structures and methods for forming the semiconductor structures to improve the performance of the formed semiconductor structures. FIG. 10 shows a flowchart of an exemplary method for fabricating a semiconductor structure consistent with various disclosed embodiments in the present invention. FIGS. 3-9 illustrate schematic views of semiconductor structures at certain stages of the exemplary fabrication process consistent with various disclosed embodiments in the present invention.

Referring to FIG. 10, at the beginning of the fabrication process, a base structure including a substrate and a plurality of discrete fin structures formed on the substrate is provided (S301). FIG. 3 shows a schematic cross-section view of a corresponding semiconductor structure.

Referring to FIG. 3, a base structure may be provided. The base structure may include a substrate 100 and a plurality of discrete fin structures 101 formed on the substrate 100. For illustration purpose, although the base structure may include more than one fin structures 101, only one fin structure 101 of the base structure is shown in FIG. 3. In other embodiments, the semiconductor structure may include a plurality of planar transistors, and accordingly, the base structure may be a planar base structure.

The substrate 100 may be used to provide a process operation platform. In one embodiment, the substrate 100 may be made of single-crystalline silicon. In other embodiments, the substrate may be made of poly-crystalline silicon, amorphous silicon, SiGe, SiC, silicon on insulator (SOI), germanium on insulator (GOI), glass, or a Group III-V compound such as GaN, GaAs, etc. The material of the substrate may be selected to meet the process requirements or for easy integration.

The fin structure 101 may be used to provide a channel for the corresponding fin field-effect transistor (Fin-FET). In one embodiment, the plurality of fin structures 101 and the substrate 100 may be made of a same material. For example, the plurality of fin structures 101 and the substrate 100 may both be made of single-crystalline silicon. In other embodiments, the plurality of fin structures may be made of a material different from the material used to form the substrate. For example, when the substrate is made of silicon, the plurality of fin structures may be made of germanium, SiGe, SiC, GaAs, and any other appropriate material suitable for forming fin structures but other than silicon.

Further, the substrate 100 and the plurality of fin structures 101 may be formed simultaneously. The process to form the substrate 100 and the plurality of fin structures 101 may include the following steps. First, an initial substrate is provided. A fin-structure mask layer (not shown) may then be formed on the surface of the initial substrate. Further, the initial substrate may be etched by using the fin-structure mask layer as an etch mask to simultaneously form the substrate 100 and the plurality of the fin structures 101 on the substrate 100.

The fin-structure mask layer may be used to define the dimensions and the positions of the fin structures 101. Moreover, the fin-structure mask layer may be formed by a process including the following steps. First, a mask material layer may be formed on the initial substrate. A patterned layer may then be formed on the mask material layer. Further, the mask material layer may be etched using the patterned layer as an etch mask until the initial substrate is exposed. As such, the fin-structure mask layer may be formed.

The patterned layer formed on the mask material layer may be used to pattern the mask material layer, and thus define the dimensions and the positions of the fin structures.

In one embodiment, the patterned layer is a patterned photoresist layer. The patterned photoresist layer may be formed through a spin-coating process followed by a photolithography process. In other embodiments, in order to reduce the feature size of the fin structures and the distance between adjacent fin structures and also to improve the integration level of the formed semiconductor structure, the patterned layer may be a mask formed by a multiple-patterned masking process. Specifically, the multiple-patterned masking process may include self-aligned double patterned (SaDP) process, self-aligned triple patterned (SaTP) process, self-aligned double double patterned (SaDDP) process, etc.

In one embodiment, after forming the substrate 100 and the plurality of fin structures 101, the fin-structure mask layer formed on the top of the fin structures 101 may be retained. The fin-structure mask layer may be made of SiNₓ. Moreover, the fin-structure mask layer may be used to define the position of the stop layer for a subsequently performed planarization process and may also provide protection for the fin structures 101.

In one embodiment, after forming the substrate 100 and the fin structure 101, the fabrication method may also include forming an isolation layer (not shown) on the portion of the substrate 100 not covered by the plurality of fin structures 101. The top surface of the isolation layer may be lower than the top surfaces of the fin structures 101 and may cover a portion of the sidewall surfaces of each fin structure 101.

The isolation layer may be used to electrically isolate neighboring fin structures and also electrically isolate neighboring semiconductor structures.

In one embodiment, the isolation layer may be made of SiOₓ. In other embodiments, the isolation layer may be made of SiNₓ, SiON, or any other appropriate material.

The process to form the isolation layer may include the following steps. First, an isolation material layer may be formed on the portion of the substrate 100 exposed by the plurality of fin structures 101 through chemical vapor deposition (CVD), e.g. fluid chemical vapor deposition. The isolation material layer may also cover the fin-structure mask layer. Further, the portion of the isolation material layer formed above the top surface of the fin-structure mask layer may be removed through chemical mechanical polishing (CMP). Moreover, a top portion of the remaining isolation material layer may be removed by a back etching process to form the isolation layer.

Further, returning to FIG. 10, a dielectric layer may be formed on the base structure (S302).

Referring to FIG. 3, a dielectric layer 104 may be formed on the base structure. The dielectric layer 104 may be used to electrically isolate neighboring semiconductor structures and also define the dimensions and the positions of subsequently-formed gate structures.

In one embodiment, the dielectric layer 104 may be made of SiOₓ. In other embodiments, the dielectric layer may be made of SiNₓ, SiON, SiCON, or any other appropriate dielectric material.

In one embodiment, the base structure may include the substrate 100, the plurality of fin structures 101 formed on the substrate 100, and the isolation layer formed between neighboring fin structures 101. Accordingly, the dielectric layer 104 may be formed on the substrate 100, the plurality of fin structures 101, and the isolation layer.

Moreover, after providing the base structure and prior to forming the dielectric layer 104, the fabrication method may also include forming a plurality of dummy gate structures 102 on the base structure and forming source/drain doped regions 103 on the two opposite sides of each dummy gate structure 102.

The plurality of dummy gate structures 102 may be used to occupy space positions for the subsequently-formed gate structures.

In one embodiment, the semiconductor structure to be formed is a Fin-FET device and the base structure of the Fin-FET device may include the substrate 100 and the plurality of fin structures 101. Therefore, the plurality of dummy gate structures 102 may be formed across the fin structures 101 and may cover a portion of the top and the sidewall surfaces of each fin structure 101.

In one embodiment, each dummy gate structure 102 may have a single-layer structure including a dummy gate electrode made of poly-crystalline silicon. In some other embodiments, the dummy gate electrodes may be made of SiOₓ, SiNₓ, SiON, SiC, SiSN, SiCON, amorphous silicon, or any other appropriate material. Moreover, the dummy gate structure may alternatively have a multiple-layer structure. For example, the dummy gate structure may include a dummy gate electrode and a dummy oxide layer formed on the dummy gate electrode. The dummy oxide layer may be made of SiOₓ, SiON, etc.

The process to form the plurality of dummy gate structures 102 may include the following steps. First, a dummy gate-structure material layer may be formed on the base structure. A dummy gate-structure mask layer may then be formed on the dummy gate-structure material layer. Further, the dummy gate structures 102 may be formed by etching the dummy gate-structure material layer using the dummy gate-structure mask layer as an etch mask.

In one embodiment, after forming the plurality of dummy gate structures 102, a sidewall spacer (not shown) may be formed on each sidewall surface of the dummy gate structures 102. The sidewall spacer may be made of one or more of SiOₓ, SiNₓ, SiC, SiCN, SiCON, SION, BN, BCN, etc. The sidewall spacer may have a single-layer structure or a multiple-layer structure. In one embodiment, each sidewall spacer has a single-layer structure made of SiNₓ.

The source/drain doped regions 103 may be further used to form a plurality of source/drain regions of the subsequently-formed semiconductor structure.

In one embodiment, the semiconductor structure to be formed is a Fin-FET device, the plurality of source/drain doped regions 103 may be formed in the fin structures 101 on the two opposite sides of each dummy gate structure 102.

Further, in one embodiment, the transistors of the semiconductor structure to be formed may be N-type metal-oxide-semiconductor (NMOS) transistors, and accordingly, the doping ions in the source/drain doped regions 103 may be N-type ions, such as P ions, As ions, and Sb ions. In other embodiments, the transistors of the semiconductor structure to be formed may be P-type metal-oxide-semiconductor (PMOS) transistors, and accordingly, the doping ions in the source/drain doped regions 103 may be P-type ions, such as B ions, Ga ions, and In ions.

In one embodiment, because a plurality of dummy gate structures 102 are formed on the base structure, during the process to form the dielectric layer 104, the dielectric layer 104 may expose the plurality of dummy gate structures 102. That is, the dielectric layer 104 may not be formed on the dummy gate structures 102. For example, the dielectric layer 104 may be formed by a process including the following steps. First, a dielectric material layer may be formed on the base structure through CVD, e.g. fluid CVD. The dielectric material layer may cover the plurality of dummy gate structures 102. The portion of the dielectric material layer formed above the top surfaces of the dummy gate structures 102 may then be removed by a CMP process or any other appropriate process. After removing the portion of the dielectric material layer formed above the top surfaces of the dummy gate structures 102, the plurality of dummy gate structures 102 may be exposed. As such, the remaining portion of the dielectric material layer may become the dielectric layer 104.

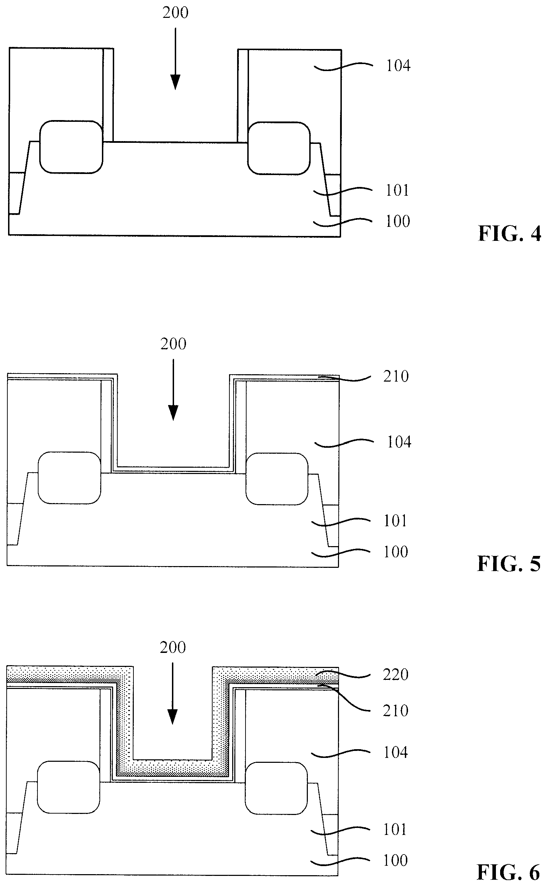

Further, returning to FIG. 10, a plurality of openings may be formed in the dielectric layer with each opening exposing a portion of the top and the sidewall surfaces of a corresponding fin structure (S303). FIG. 4 shows a schematic cross-section view of a corresponding semiconductor structure.

Referring to FIG. 4, corresponding to each fin structure 101, an opening 200 may be formed in the dielectric layer 104 to expose a portion of the base structure. For example, each opening 200 may expose a portion of the top and the sidewall surfaces of a corresponding fin structure 101. The plurality of openings 200 may be used to provide process spaces for subsequently-formed gate structures.

In one embodiment, prior to forming the plurality of openings 200 in the dielectric layer 104, a plurality of dummy gate structures 102 (referring to FIG. 3) are formed on the base structure. Accordingly, during the process to form the plurality openings 200 in the dielectric layer 104, the plurality of dummy gate structures 102 may be removed to expose the base structure and thus form the plurality of openings 200.

In one embodiment, the semiconductor structure to be formed is a Fin-FET device and the base structure of the semiconductor structure may include the substrate 100 and the plurality of fin structures 101. Moreover, the dummy gate structures may be formed across each fin structure 101 and may cover a portion of the top and the sidewall surfaces of each fin structure 101. Therefore, after forming the plurality of openings 200, the bottom of each opening 200 may expose a portion of the top and the sidewall surfaces of the corresponding fin structure 101.

In one embodiment, the dummy gate structure 102 (referring to FIG. 3) has a single layer structure including a dummy gate electrode, and the dummy gate electrode is made of poly-crystalline silicon. Accordingly, the dummy gate structure 102 may be removed by a dry etching process, a wet etching process, or a process combining both dry etching and wet etching. The etching process may demonstrate a high selective etching ratio. That is, during the etching process, the etch rate on the dummy gate structure 102 may be much larger than the etch rate on the dielectric layer 104. Therefore, during the removal of the dummy gate structure 102, the consumption of the dielectric layer 104 may be limited and neglected.

Further, returning to FIG. 10, a gate dielectric layer may be formed on the bottom and the sidewall surfaces of each opening (S304). FIG. 5 shows a schematic cross-section view of a corresponding semiconductor structure.

Referring to FIG. 5, a gate dielectric layer 210 may be formed on the bottom and the sidewall surfaces of each opening 200. The gate dielectric layer 210 may be used to electrically isolate the subsequently-formed gate structure from the corresponding channel in the base structure.

Further, the gate dielectric layer 210 may be made of a high-k dielectric material. The high-k dielectric material may refer to a dielectric material with a relative dielectric constant greater than the relative dielectric constant of SiOₓ. In one embodiment, the gate dielectric layer 210 may be made of HfO₂. In other embodiments, the gate dielectric layer may be made of ZrO₂, HfSiO, HfSiON, HfTaO, HfTiO, HfZrO, Al₂O₃, etc.

In one embodiment, the semiconductor structure to be formed is a Fin-FET device and the bottom of each opening 200 may expose a portion of the top and the sidewall surfaces of the corresponding fin structure 100. Accordingly, the gate dielectric layer 210 may be formed across each fin structure 101 covering the portion of the fin structure 101 exposed in each opening 200.

In one embodiment, the gate dielectric layer 210 may be formed on the bottom of the opening 200 through an atomic layer deposition (ALD) process. In other embodiments, the gate dielectric layer may be formed through a CVD, physical vapor deposition (PVD), or any other appropriate deposition process.

In one embodiment, after forming the opening 200 and prior to forming the gate dielectric layer 210, the fabrication method may also include forming an interfacial layer (not shown) on the bottom of each opening 200. The interfacial layer may provide a desired interface basis for the subsequent formation of the gate dielectric layer 210. As such, the quality of the formed gate dielectric layer 210 may be improved, and the properties of the interface between the gate dielectric layer 210 and the corresponding fin structure 101 may also be improved. In addition, the interfacial layer together with the gate dielectric layer 210 may form a multiple-layer structure to electrically isolate the formed gate structure from the corresponding channel in the base structure.

In one embodiment, the interfacial layer may be made of SiOₓ and may be formed through a thermal-oxidation process. In other embodiment, the interfacial layer may be made of SiCON or any other appropriate material. Moreover, the interfacial layer may be formed through a CVD, PVD, ALD, or any other appropriate deposition process. Further, the gate dielectric layer 210 may then be formed on the interfacial layer on the bottom and the sidewall surfaces of each opening 200.

Further, returning to FIG. 10, an Al-containing work function layer may be formed on the gate dielectric layer and the atomic concentration of the Al atoms in the Al-containing work function layer may become gradually smaller along a direction from the gate dielectric layer to the top of the opening (S305). FIG. 6 shows a schematic cross-section view of a corresponding semiconductor structure.

Referring to FIG. 6, an Al-containing work function layer 220 may be formed on the gate dielectric layer 210 in each opening 200. Moreover, the Al atoms may not be uniformly distributed in the Al-containing work function layer 220. The ratio of the number of the Al atoms to the total number of the atoms at a given position of the Al-containing work function layer 220 may be referred to as an atomic concentration of the Al atoms. Therefore, the atomic concentration of the Al atoms may be a local ratio that can vary in the Al-containing work function layer 220 as the position changes. Specifically, in one embodiment, the atomic concentration of the Al atoms in the Al-containing work function layer 220 may gradually decrease along a direction from the gate dielectric layer 210 to the top of the opening 200.

The Al-containing work function layer 220 may be used to adjust the threshold voltage of the corresponding transistor of the semiconductor structure. In one embodiment, the transistors of the semiconductor structure are NMOS transistors. Accordingly, the Al-containing work function layer 220 is thus used to adjust the threshold voltage of the corresponding NMOS transistor.

In one embodiment, the gate dielectric layer 210 is formed on the bottom and the sidewall surfaces of the opening 200, and thus during the process to form the Al-containing work function layer 220, the Al-containing work function layer 220 may be formed on the bottom and the sidewall surfaces of the opening 200.

During the early stage for forming the Al-containing work function layer 220, the portion of the Al-containing work function layer 220 deposited on the sidewall surfaces of the opening 200 may still be relatively thin, and the top dimension of the opening 200 may be relatively large. Therefore, the deposition loading effect of the Al atoms may be weak, and thus, forming an Al-containing work function layer 220 with a relatively high atomic concentration of the Al atoms may be less difficult. With the continue formation of the Al-containing work function layer 220, the top dimension of the opening may decrease, and the deposition loading effect of Al atoms may become more prominent. However, according to the disclosed fabrication method, because the atomic concentration of the Al atoms in the formed Al-containing work function layer 220 becomes smaller, the process difficulty for forming the Al-containing work function layer 220 may be reduced. Therefore, the method to gradually decrease the atomic concentration of the Al atoms in the Al-containing work function layer 220 along the direction from the dielectric layer 210 to the top of the opening 200 may be conducive to reducing the process difficulty for forming the Al-containing work function layer 220 and solving the threshold voltage roll-up issue in transistors. As such, the performance of the formed semiconductor structure may be improved.

Further, during the process to form the Al-containing work function layer 220, the atomic concentration of the Al atoms in the Al-containing work function layer 220 may not be too large or too small. When the atomic concentration of the Al atoms in the Al-containing work function layer 220 is overly large, the work function value of the Al-containing work function layer 220 may be too low. Further, when the atomic concentration of the Al atoms in the Al-containing work function layer 220 is too small, the work function value of the Al-containing work function layer 220 may be excessively large. With an excessively large or small work function value, the Al-containing work function layer 220 may not be able to adjust the threshold voltage of the transistor. In one embodiment, during the process to form the Al-containing work function layer 220, the atomic concentration of the Al atoms is in a range of approximately 40% to 75%. That is, the atomic concentration of the Al atoms in the Al-containing function layer 220 is not higher than 75% or lower than 40%.

In addition, the transistors of the semiconductor structure to be formed are NMOS transistors, the Al-containing work function layer 220 is used to adjust the threshold voltage of the corresponding NMOS transistor. In order to ensure that the Al-containing work function layer 220 provides desired adjustment on the threshold voltage of the NMOS transistor, the average atomic concentration of the Al atoms in the Al-containing work function layer 220 may not be too large or too small. The average atomic concentration of the Al atoms in the Al-containing work function layer 220 may represent the ratio of the number of the Al atoms to the total number of atoms in the entire Al-containing work function layer 220.

When the average atomic concentration of the Al atoms in the Al-containing work function layer 220 is too high, the work function value of the formed Al-containing work function layer 220 may be too small. When the average atomic concentration of the Al atoms in the Al-containing work function layer 220 is too low, the work function value of the Al-containing work function layer 220 may be too large. Moreover, with an excessively large or small work function value, the Al-containing work function layer 220 may not be able to adjust the threshold voltage of the transistor. Therefore, during the process to form the Al-containing work function layer 220, the average atomic concentration of the Al atoms may be in a range of approximately 60% to 70%.

In one embodiment, the Al-containing work function layer 220 may be made of TiAl or TaAl. In other embodiments, during the process to form the Al-containing work function layer, the Al-containing work function layer may be made of one or more of TiAlC, TaAlN, TiAIN, and AlN. Therefore, in the Al-containing work function layer 220, the ratio between Al atoms and Ti atoms may be in a range of approximately 0.7 to 2.5, or the ratio between Al atoms and Ta atoms may be in a range of approximately 0.7 to 2.5.

Moreover, the thickness of the work function layer may also affect the work function value of the formed work function layer. Therefore, in one embodiment, the thickness of the Al-containing work function layer may not be too large or too small.

When the thickness of the Al-containing work function layer 220 is overly large, the work function value of the Al-containing work function layer may be too large; while when the thickness of the Al-containing work function layer 220 is too small, the work function value of the Al-containing work function layer 220 may be too large. With an excessively large or small work function value, the Al-containing work function layer 220 may not be able to adjust the threshold voltage of the transistor. In one embodiment, the thickness of the formed Al-containing work function layer 220 may be in a range of approximately 30 Å to 70 Å.

Moreover, the Al-containing work function layer 220 may be formed by an ALD process. For example, at least one deposition of an Al-containing material may be used to form the Al-containing work function layer 220, and each deposition of the Al-containing material may include introducing an Al-containing precursor and later removing the Al-containing precursor through purging.

In one embodiment, the Al-containing precursor may be AlCH₃, i.e. trimethylaluminum (TMA). After introducing the Al-containing precursor, the molecules of the Al-containing precursor may react with the surface of the gate dielectric layer 210, and may be absorbed on the surface of the gate dielectric layer 210. As such, the Al-containing precursor may be deposited on the gate dielectric layer 210. The process to purge the Al-containing precursor may include removing the remaining portion of the Al-containing precursor from the reaction chamber.

During the early stage of the formation of the Al-containing work function layer 220, the top dimension of the opening 200 may be large, it is less difficult for the molecules of the Al-containing precursor to enter the opening 200, and thus the deposition loading effect of the Al atoms may be weak. Therefore, forming an Al-containing work function layer 220 with a relatively high atomic concentration of the Al atoms may be less difficult. With the continuous decrease of the top dimension of the opening 200 due to the formation of the Al-containing work function layer 220 in the opening 200, it becomes more difficult for the molecules of the Al-containing precursor to enter the opening 200, and thus the deposition loading effect of Al atoms may increase. However, according to the disclosed fabrication method, because the atomic concentration of the Al atoms in the formed Al-containing work function layer 220 also becomes smaller, the challenges of the process to form the Al-containing work function layer 220 may be reduced. Further, reducing the process difficulty for forming the Al-containing work function layer 220 may be conducive to improving the properties of the formed transistor and the performance of the formed semiconductor structure.

In one embodiment, the process to form the Al-containing work function layer 220 may include multiple times of deposition of an Al-containing material. In order to ensure that along the direction from the gate dielectric layer 210 to the top of the opening 200, the atomic concentration of the Al atoms in the Al-containing work function layer 220 becomes smaller, during the multiple times of the deposition of the Al-containing material, the pulse time for introducing the Al-containing precursor in each deposition may gradually decrease.

Further, the pulse time for introducing the Al-containing precursor in each deposition may not be too short or too long. When the pulse time for introducing the Al-containing precursor in each deposition is too long, the deposition probability of the Al atoms may be too large, and thus an excessively large number of the atoms may be deposited during the deposition process of the Al-containing material. Therefore, the average atomic concentration of the Al atoms in the formed Al-containing work function layer 220 may be too large, and accordingly, the work function value of the Al-containing work function layer 220 may be too small. When the pulse time for introducing the Al-containing precursor in each deposition is too short, the deposition probability of Al atoms may be too small, and thus too few Al atoms may be deposited during the deposition process of the Al-containing material. Therefore, the average atomic concentration of the Al atoms in the formed Al-containing work function layer 220 may be too small, and accordingly, the work function value of the Al-containing work function layer 220 may be too large.

Further, with an excessively large or small work function value, the Al-containing work function layer 220 may not be able to adjust the threshold voltage of the transistor. In one embodiment, during the process to introduce the Al-containing precursor, the pulse time for introducing the Al-containing precursor in each deposition may be in a range of approximately 8 seconds to 25 seconds. That is, when performing the multiple times of the deposition of the Al-containing material, the longest pulse time for introducing the Al-containing precursor in each deposition may not be longer than approximately 25 seconds, and the shortest pulse time for introducing the Al-containing precursor in each deposition may not be shorter than approximately 8 seconds.

Moreover, along the direction from the gate dielectric layer 210 to the top of the opening 200, the atomic concentration of the Al atoms in the Al-containing work function layer 220 may decrease. When multiple times of the deposition of the Al-containing material are performed to form the Al-containing work function layer 220, during the multiple-deposition process, the flow rate for introducing the Al-containing precursor in each deposition may gradually decrease.

Further, the flow rate for introducing the Al-containing precursor in each deposition may not be too large or too small. When the flow rate for introducing the Al-containing precursor in each deposition is too large, the deposition probability of Al atoms may also be too large, and thus an excessively large number of the Al atoms may be deposited during the deposition process of the Al-containing material. Therefore, the average atomic concentration of the Al atoms in the formed Al-containing work function layer 220 may be too large, and accordingly, the work function value of the Al-containing work function layer 220 may be too small. When the flow rate for introducing the Al-containing precursor in each deposition is too small, the deposition probability of Al atoms may also be too small, and thus a relatively small number of the Al atoms may be deposited during the deposition process of the Al-containing material. Therefore, the average atomic concentration of the Al atoms in the formed Al-containing work function layer 220 may be too small, and accordingly, the work function value of the Al-containing work function layer 220 may be too large.

Further, with an excessively large or small work function value, the Al-containing work function layer 220 may not be able to adjust the threshold voltage of the transistor. In one embodiment, during the process to introduce the Al-containing precursor, the flow rate for introducing the Al-containing precursor in each deposition may be in a range of approximately 200 sccm to 600 seem. That is, when performing the multiple times of the deposition of the Al-containing material, the largest flow rate for introducing the Al-containing precursor in each deposition may not be larger than approximately 600 seem, and the smallest flow rate for introducing the Al-containing precursor in each deposition may not be smaller than approximately 200 seem.

Moreover, during each deposition of the Al-containing material, the deposition probability of Al atoms may be related to both the density of the Al-containing precursor and the pulse time for introducing the Al-containing precursor. Therefore, corresponding to a longer pulse time for introducing the Al-containing precursor and/or a larger flow rate for introducing the Al-containing precursor in each deposition, the deposition probability of the Al atoms may be larger, and thus more Al atoms may be deposited during the deposition process of the Al-containing material. Therefore, during each deposition of the Al-containing material, the pulse time for introducing the Al-containing precursor and the flow rate for introducing the Al-containing precursor may be coordinately controlled in appropriate ranges in order to ensure that the formed Al-containing work function layer 220 reaches target values and the threshold voltage of the formed transistor meets design requirements.

In one embodiment, the transistors of the semiconductor structure to be formed are NMOS transistors. The Al-containing material used to form the work functional layer is an N-type work function material, and the work function value of the N-type work function material may be in a range approximately from 3.9 eV to 4.5 eV, such as 4 eV, 4.1 eV, 4.3 eV, etc. In other embodiments, the transistors of the semiconductor structure to be formed may be PMOS transistors. Accordingly, the fabrication method may further include forming a P-type work function layer on the gate dielectric layer 210 after forming the gate dielectric layer and prior to forming the Al-containing work function layer. The Al-containing work function layer may be used to adjust the threshold voltages of the NMOS transistors formed in other regions of the base structure. The Al-containing work function layer may have limited effects on the threshold voltages of PMOS transistors. Therefore, during the formation of the Al-containing work function layer, the frequency of using the mask may be reduced. In addition, after forming the Al-containing work function layer, the Al-containing work function layer may not be removed in order to reduce the number of the process steps, and thus reduce the process cost.

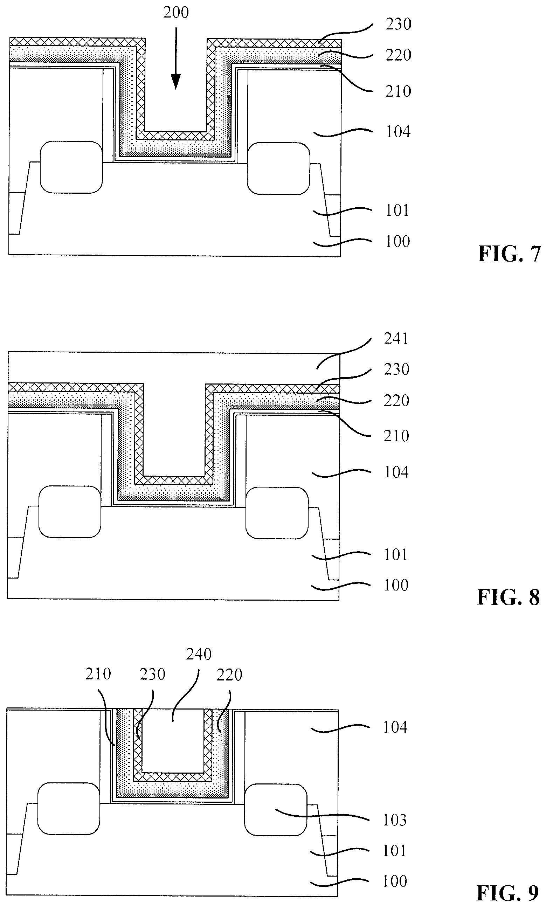

Further, returning to FIG. 10, a barrier layer may be formed on the Al-containing work function layer (S306). FIG. 7 shows a schematic cross-section view of a corresponding semiconductor structure.

Referring to FIG. 7, a barrier layer 230 may be formed on the Al-containing work function layer 220. The barrier layer 230 may be used to provide protection for the Al-containing work function layer 220 such that diffusion of impurity ions into the work function layer 220 in a subsequent process may be avoided. Therefore, the formation of the barrier layer 230 may be conducive to reducing the work function value of the work function layer 220 and also conducive to reducing the threshold voltage of the formed transistor. The barrier layer 230 may also be used to improve the adhesion ability of a subsequently-formed metal layer, and thus may be conducive to improving the reliability of the formed gate structure.

In one embodiment, the barrier layer 230 is made of TiN and is formed by an ALD process. In other embodiments, the barrier layer may be made of TiSiN, and in addition, the barrier layer may be formed through a CVD, PVD, or any other appropriate deposition process.

The thickness of the barrier layer 230 may not be too large or too small. When the thickness of the barrier layer 230 is too small, the barrier layer 230 may not be able to provide sufficient protection for the Al-containing work function layer 220, and thus may not be conducive to reducing the threshold voltage of the formed transistor. In addition, the barrier layer 230 with such a small thickness may not be conducive to improving the adhesion ability of the subsequently-formed metal layer, and thus may not be conducive to improving the reliability of the formed transistor. When the thickness of the barrier layer 230 is too large, the overly large thickness of the barrier layer 230 may lead to problems such as material waste and increased process challenges. In addition, the barrier layer 230 may occupy an excessively large space in the opening 200, leading to an increased aspect ratio of the opening 200 after forming the barrier layer 230, which may not be conducive to the subsequent film formation. In one embodiment, the thickness of the barrier layer 230 may be in a range of approximately 20 Å to 60 Å.

Further, returning to FIG. 10, after forming the barrier layer, a conductive material may be filled into each opening to form a metal material layer (S307). FIG. 8 shows a schematic cross-section view of a corresponding semiconductor structure.

Referring to FIG. 8, after forming the barrier layer 230, a conductive material may be filled into each opening 200 (referring to FIG. 7) to form a metal material layer 241. The metal material layer 241 may also be formed on the dielectric layer 104. The metal material layer 241 may be formed by a CVD, PVD, ALD, electroplating, or any other appropriate method.

Further, returning to FIG. 10, the portion of the metal material layer formed above the surface of the dielectric layer may be removed to form a metal layer (S308). FIG. 9 shows a schematic cross-section view of a corresponding semiconductor structure.

Referring to FIG. 9, the portion of the metal material layer 241 formed above the surface of the dielectric layer 104 may be removed to form a metal layer 240. The metal layer 240 may be used as an electrode to electrically connect to external circuits.

In one embodiment, the metal layer 240 is made of W. In other embodiments, the metal layer 240 may be made of Al, Cu, Ag, Au, Pt, Ni, Ti, or any other appropriate material.

In addition, as shown in FIG. 8, the gate dielectric layer 241, the Al-containing work function layer 220, and the barrier layer 230 are consecutively formed on the dielectric layer 104. Accordingly, the process to remove the portion of the metal material layer 241 formed above the surface of the dielectric layer 104 may include removing the portion of the gate dielectric layer 241, the Al-containing work function layer 220, and the barrier layer 230 formed on the dielectric layer 104 together with the portion of the metal material layer 241 (referring to FIG. 8) formed above the surface of the dielectric layer 104. As such, the remaining portion of the metal material layer 241 may form the metal layer 240 filling up the corresponding opening 200 (referring to FIG. 7).

The metal layer 240, the Al-containing work function layer 220, and the gate dielectric layer 210 may be used to form a gate structure. In one embodiment, the gate structure may be formed by the metal layer 240, the Al-containing work function layer 220, the gate dielectric layer 210, and the barrier layer 230. In addition, the formed semiconductor structure may include a plurality of gate structures.

Further, in one embodiment, the semiconductor structure is a Fin-FET device and the base structure of the Fin-FET device may include the substrate 100 and the plurality of fin structures 101. Accordingly, the plurality of gate structures may be formed across the fin structures 101 and cover a portion of the top and the sidewall surfaces of each fin structure 101.

Further, the present invention also provides a semiconductor structure. The semiconductor structure may include a plurality of transistors. FIG. 9 illustrates a schematic cross-section view of an exemplary semiconductor structure consistent with various embodiments of the present invention. For illustration purpose, only one transistor is shown in FIG. 9, although the semiconductor structure may include two or more transistors.

Referring to FIG. 9, the semiconductor structure may include a base structure, a dielectric layer 104 formed on the base structure, a plurality of gate structures corresponding to the plurality of transistors. Each gate structure may further include a metal layer 240 formed in the dielectric layer 104, an Al-containing work function layer 220 and a gate dielectric layer 210 formed between the dielectric layer 104 and the metal layer 240 and also between the metal layer 240 and the base structure. Specifically, the Al-containing work function layer 220 may be formed between the metal layer 240 and the gate dielectric layer 210. Moreover, the Al atoms may not be uniformly distributed in the Al-containing work function layer 220. The ratio of the number of the Al atoms to the total number of the atoms at a given position of the Al-containing work function layer 220 may be referred to as an atomic concentration of the Al atoms. Therefore, the atomic concentration of the Al atoms may be a local ratio that can vary in the Al-containing work function layer 220 as the position changes. Specifically, in one embodiment, along a direction from the gate dielectric layer 210 to the metal layer 240, the atomic concentration of the Al atoms in the Al-containing work function layer 220 may gradually decrease.

The base structure may be used to provide a basis for process operation. In one embodiment, the semiconductor structure is a Fin-FET device. Accordingly, the base structure may include a substrate 100 and a plurality of discrete fin structures 101 formed on the substrate 100. In other embodiments, the semiconductor structure may be a planar transistor device including a plurality of planar transistors. Accordingly, the base structure may be a planar base structure.

The substrate 100 may be used to provide a process operation platform. In one embodiment, the substrate 100 may be made of single-crystalline silicon. In other embodiments, the substrate may be made of poly-crystalline silicon, amorphous silicon, SiGe, SiC, SOI, GOI, glass, or a Group III-V compound such as GaN, GaAs, etc. The material of the substrate may be selected to meet the process requirements or for easy integration.

The fin structures 101 may be used to provide a channel for the Fin-FET. In one embodiment, the plurality of fin structures 101 may be made of the same material as the material used to form the substrate 100. That is, the plurality of fin structures 101 may also be made of single-crystalline silicon. In other embodiments, the plurality of fin structures may be made of a material different from the material used to form the substrate. For example, the plurality of fin structures 101 may be made of germanium, SiGe, SiC, GaAs, and any other appropriate material suitable for forming fin structures.

Further, the semiconductor structure may also include an isolation layer (not shown) formed on the portion of the substrate 100 not covered by the plurality of fin structures 101. The top surface of the isolation layer may be lower than the top surfaces of the fin structures 101 and may cover a portion of the sidewall surfaces of each fin structure 101.

The isolation layer may be used to electrically isolate neighboring fin structures and also electrically isolate neighboring semiconductor structures.

In one embodiment, the isolation layer may be made of SiOₓ. In other embodiments, the isolation layer may be made of SiNₓ, SiON, or any other appropriate material.

The dielectric layer 104 may be used to electrically isolate neighboring semiconductor structures and also define the dimensions and the positions of subsequently-formed gate structures.

In one embodiment, the dielectric layer 104 may be made of SiOₓ. In other embodiments, the dielectric layer may be made of SiNₓ, SiON, SiCON, or any other appropriate dielectric material.

In one embodiment, the base structure may include the substrate 100, the plurality of fin structures 101 formed on the substrate 100, and the isolation layer formed between neighboring fin structures 101. Accordingly, the dielectric layer 104 may be formed on the substrate 100, the plurality of fin structures 101, and the isolation layer.

Each gate structure may be used to control the channel of the corresponding transistor to switch between a conduction state and a cut-off state. Specifically, when the channel of the transistor is in a conduction state, the transistor may be turned on; while when the channel of the transistor is in a cut-off state, the transistor may be turned off.

In one embodiment, the plurality of transistors may be Fin-FETs. Therefore, each gate structure may be formed across the corresponding fin structure 101 and on a portion of the top and the sidewall surfaces of the fin structure 101. The fin structure may include a gate dielectric layer 210, an Al-containing work function layer 220, and a metal layer 240.

The gate dielectric layer 210 may be used to electrically isolate the subsequently-formed gate structure from the corresponding channel in the base structure. The gate dielectric layer 210 may be formed between the bottom of the metal layer 240 and the base structure and also between the sidewalls of the metal layer 240 and the dielectric layer 104.

The gate dielectric layer 210 may be made of a high-k dielectric material. In one embodiment, the gate dielectric layer 210 may be made of HfO₂. In other embodiments, the gate dielectric layer may be made of ZrO₂, HfSiO, HfSiON, HfTaO, HfTiO, HfZrO, Al₂O₃, etc.

In one embodiment, the semiconductor structure is a Fin-FET device. Therefore, the gate dielectric layer 210 may be formed across the fin structure 101 and on a portion of the top and the sidewall surfaces of the fin structure 101.

Moreover, the semiconductor structure may also include an interfacial layer (not shown) formed between the gate dielectric layer 210 and the corresponding fin structure 101. The interfacial layer may provide a desired interface basis for the subsequent formation of the gate dielectric layer 210. As such, the quality of the formed gate dielectric layer 210 may be improved, and thus the properties of the interface between the gate dielectric layer 210 and the corresponding fin structure 101 may also be improved. In addition, the interfacial layer together with the gate dielectric layer 210 may form a multiple-layer structure to electrically isolate the formed gate structure from the corresponding channel in the base structure.

In one embodiment, the interfacial layer may be made of SiOₓ and formed by a thermal-oxidation process. In other embodiments, the interfacial layer may be made of SiCON or any other appropriate material.

The Al-containing work function layer 220 may be used to adjust the threshold voltage of the corresponding transistor of the formed semiconductor structure. In one embodiment, the transistors of the semiconductor structure are NMOS transistors. Accordingly, the Al-containing work function layer 220 is thus used to adjust the threshold voltage of the corresponding NMOS transistor.

A portion of the Al-containing work function layer 220 may be formed between the metal layer 240 and the base structure. In addition, another portion of the Al-containing work function layer 220 may be formed between the sidewalls of the metal layer 240 and the dielectric layer 104.

Therefore, during the early stage of the formation of the Al-containing work function layer 220, the portion of the Al-containing work function layer 220 deposited on the sidewall surfaces of the opening 200 may still be relatively thin, and the deposition loading effect of the Al atoms may be weak. Therefore, the process to form an Al-containing work function layer 220 with a relatively high atomic concentration of the Al atoms may be less difficult. With the continue formation of the Al-containing work function layer 220, further deposition of the Al-containing work function layer 220 may be more difficult, and thus the deposition loading effect of Al atoms may increase. However, according to the disclosed semiconductor structure, because the atomic concentration of the Al atoms in the formed Al-containing work function layer 220 becomes smaller, the challenges of the process to form the Al-containing work function layer 220 may be reduced. Therefore, the method to gradually decrease the atomic concentration of the Al atoms in the Al-containing work function layer 220 along the direction from the dielectric layer 210 to the top of the opening 200 may be conducive to reducing the process difficulty for forming the Al-containing work function layer 220 and solving the threshold voltage roll-up issue in transistors. As such, the performance of the formed semiconductor structure may be improved.

Moreover, along the direction from the dielectric layer 210 to the metal layer 240, the atomic concentration of the Al atoms in the Al-containing work function layer 220 may not be too large or too small. When the atomic concentration of the Al atoms in the Al-containing work function layer 220 is overly large, the work function value of the Al-containing work function layer 220 may be too low. Moreover, when the atomic concentration of the Al atoms in the Al-containing work function layer 220 is too small, the work function value of the Al-containing work function layer 220 may be excessively large. With an excessively large or small work function value, the Al-containing work function layer 220 may not be able to adjust the threshold voltage of the transistor. In one embodiment, during the process to form the Al-containing work function layer 220, the atomic concentration of the Al atoms is in a range of approximately 40% to 75%. That is, the atomic concentration of the Al atoms in the Al-containing function layer 220 is not higher than 75% or lower than 40%.

In addition, the transistors of the semiconductor structure to be formed are NMOS transistors, the Al-containing work function layer 220 is used to adjust the threshold voltage of the corresponding NMOS transistor. In order to ensure that the Al-containing work function layer 220 provides desired adjustment on the threshold voltage of the NMOS transistor, the average atomic concentration of the Al atoms in the Al-containing work function layer 220 may not be too large or too small. The average atomic concentration of the Al atoms in the Al-containing work function layer 220 may represent the ratio of the number of the Al atoms to the total number of atoms in the entire Al-containing work function layer 220.

When the average atomic concentration of the Al atoms in the Al-containing work function layer 220 is too high, the work function value of the formed Al-containing work function layer 220 may then be too small. When the average atomic concentration of the Al atoms in the Al-containing work function layer 220 is too low, the work function value of the Al-containing work function layer 220 may then be too large. Moreover, with an excessively large or small work function value, the Al-containing work function layer 220 may not be able to adjust the threshold voltage of the transistor. Therefore, during the process to form the Al-containing work function layer 220, the average atomic concentration of the Al atoms may be in a range of approximately 60% to 70%.

In one embodiment, the Al-containing work function layer 220 may be made of TiAl or TaAl. In other embodiments, during the process to form the Al-containing work function layer, the Al-containing work function layer may be made of one or more of TiAlC, TaAlN, TiAIN, and AlN. Therefore, in the Al-containing work function layer 220, the ratio between Al atoms and Ti atoms may be in a range of approximately 0.7 to 2.5, or the ratio between Al atoms and Ta atoms may be in a range of approximately 0.7 to 2.5.

Moreover, the thickness of the work function layer may also affect the work function value of the formed work function layer. Therefore, in one embodiment, the thickness of the Al-containing work function layer may not be too large or too small.

When the thickness of the Al-containing work function layer 220 is overly large, the work function value of the Al-containing work function layer may be too large; while when the thickness of the Al-containing work function layer 220 is too small, the work function value of the Al-containing work function layer 220 may be too large. With an excessively large or small work function value, the Al-containing work function layer 220 may not be able to adjust the threshold voltage of the transistor. In one embodiment, the thickness of the formed Al-containing work function layer 220 may be in a range of approximately 30 Å to 70 Å.

In one embodiment, the transistors of the semiconductor structure are NMOS transistors. The Al-containing material used to form the work functional layer is an N-type work function material, and the work function value of the N-type work function material may be in a range approximately from 3.9 eV to 4.5 eV, such as 4 eV, 4.1 eV, 4.3 eV, etc. In other embodiments, the transistors of the semiconductor structure may be PMOS transistors. Accordingly, the semiconductor structure may further include a P-type work function layer formed between each Al-containing work function layer and the corresponding metal layer. The Al-containing work function layer may be used to adjust the threshold voltages of the NMOS transistors formed in other regions of the base structure. The Al-containing work function layer may have limited effects on the threshold voltages of PMOS transistors. Therefore, during the formation of the Al-containing work function layer, the frequency of using the mask may be reduced. In addition, after forming the Al-containing work function layer, the Al-containing work function layer may not be removed in order to reduce the number of the process steps, and thus reduce the process cost.

The metal layer 240 may be used as an electrode to electrically connect to external circuits.

In one embodiment, the metal layer 240 is made of W. In other embodiments, the metal layer 240 may be made of Al, Cu, Ag, Au, Pt, Ni, Ti, or any other appropriate material.

Moreover, in one embodiment, the semiconductor structure may further include a barrier layer 230 formed between each Al-containing work function layer 220 and the corresponding metal layer 240.

The barrier layer 230 may be used to provide protection for the Al-containing work function layer 220 such that diffusion of impurity ions into the work function layer 220 in a subsequent process may be avoided. Therefore, the formation of the barrier layer 230 may be conducive to reducing the work function value of the work function layer 220 and also conducive to reducing the threshold voltage of the formed transistor. The barrier layer 230 may also be used to improve the adhesion ability of a subsequently-formed metal layer, and thus may be conducive to improving the reliability of the formed gate structure.

In one embodiment, the barrier layer 230 is made of TiN and is formed by an ALD process. In other embodiments, the barrier layer may be made of TiSiN, and in addition, the barrier layer may be formed through a CVD, PVD, or any other appropriate deposition process.

The thickness of the barrier layer 230 may not be too large or too small. When the thickness of the barrier layer 230 is too small, the barrier layer 230 may not be able to provide sufficient protection for the Al-containing work function layer 220, and thus may not be conducive to reducing the threshold voltage of the formed transistor. In addition, the barrier layer 230 with such a small thickness may not be conducive to improving the adhesion ability of the subsequently-formed metal layer, and thus may not be conducive to improving the reliability of the formed transistor. When the thickness of the barrier layer 230 is too large, the overly large thickness of the barrier layer 230 may lead to problems such as material waste and increased process challenges. In addition, the barrier layer 230 may occupy an excessively large space in the opening 200, leading to an increased aspect ratio of the opening 200 after forming the barrier layer 230, which may not be conducive to the subsequent film formation. In one embodiment, the thickness of the barrier layer 230 may be in a range of approximately 20 Å to 60 Å.

The metal layer 240, the Al-containing work function layer 220, and the gate dielectric layer 210 may together be used to form a gate structure. In one embodiment, the gate structure may be formed by the metal layer 240, the Al-containing work function layer 220, the gate dielectric layer 210, and the barrier layer 230. In addition, the semiconductor structure may include a plurality of gate structures.

Further, the semiconductor structure is a Fin-FET device, the base structure of the Fin-FET device may include the substrate 100 and the plurality of fin structures 101. Accordingly, the plurality of gate structures may be formed across the fin structures 101 and cover a portion of the top and the sidewall surfaces of each fin structure 101.

Moreover, the semiconductor structure may also include a plurality of source/drain doped regions 103 formed in the base structure on the two opposite sides of each gate structure. The source/drain doped regions 103 may be used to form the source regions or the drain regions of the transistors of the semiconductor structure. In one embodiment, the semiconductor structure is a Fin-FET device. Therefore, the source/drain regions 103 may be formed in the fin structure 101 on the two opposite sides of each gate structure. Accordingly, the dielectric layer 104 may also cover the source/drain doped regions 103.

In one embodiment, the transistors of the semiconductor structure are NMOS transistors, and accordingly, the doping ions in the source/drain doped regions 103 may be N-type ions, such as P ions, As ions, and Sb ions. In other embodiments, the transistors of the semiconductor structure to be formed may be P-type metal-oxide-semiconductor (PMOS) transistors, and accordingly, the doping ions in the source/drain doped regions 103 may be P-type ions, such as B ions, Ga ions, and In ions.

Compared to existing fabrication methods and semiconductor structures, the disclosed fabrication methods and semiconductor structures may demonstrate several advantages.

For example, as disclosed, after forming the gate dielectric layer on the bottom and the sidewall surfaces of each opening formed in the dielectric layer, an Al-containing work function layer is formed. Along the direction from the gate dielectric layer to the top of the opening, the atomic concentration of the Al atoms in the Al-work function layer may decrease. Moreover, the Al-containing work function layer may be not only formed on the bottom surface of the opening, but also on the sidewalls of the opening. Therefore, during the early stage of the formation of the Al-containing work function layer, the portion of the Al-containing work function layer deposited on the sidewall surfaces of the opening may still be relatively thin, and the top dimension of the opening may be large. Therefore, the deposition loading effect of the Al atoms may be weak, and thus, the capability for depositing Al atoms may be strong. As the thickness of the Al-containing work function layer formed on the sidewalls of the opening increases, the top dimension of the opening may decrease. Therefore, the deposition loading effect of Al atoms may increase, and thus, the capability form depositing Al atoms may be weakened. However, the atomic concentration of the Al atoms in the formed Al-containing work function layer becomes smaller along the direction from the gate dielectric layer to the top of the opening. That is, when the top dimension of the opening is relatively large, the atomic concentration of the Al atoms in the corresponding portion of the formed Al-containing work function layer is also large, and when the top dimension of the opening is reduced, the atomic concentration of the Al atoms in the corresponding portion of the formed Al-containing work function layer is also reduced. As such, the average atomic concentration of the Al atoms in the formed Al-containing work function layer may reach the designed target value, and thus may be conducive to reducing the process difficulty for forming the Al-containing work function layer and solving the threshold voltage roll-up issue in transistors. Therefore, the performance of the formed semiconductor structure may be improved.

## Claims

1. A method for fabricating a semiconductor structure, comprising:
providing a base structure;
forming a dielectric layer on the base structure;
forming a plurality of openings in the dielectric layer;
forming a gate dielectric layer on bottom and sidewall surfaces of each opening;
forming an aluminum-containing work function layer on the gate dielectric layer in each opening, wherein along a direction from the gate dielectric layer to a top of the opening, an atomic concentration of aluminum atoms in the aluminum-containing work function layer decreases; and
forming a metal layer on the aluminum-containing work function layer to fill each opening, wherein the metal layer, the aluminum-containing work function layer, and the gate dielectric layer together form a gate structure.

2. The method for fabricating the semiconductor structure according to claim 1, wherein:
the atomic concentration of the aluminum atoms in the aluminum-containing work function layer is in a range of approximately 40% to 75% by a total number of atoms in the aluminum-containing work function layer; and/or
an average atomic concentration of the aluminum atoms is in a range of approximately 60% to 70% by a total number of atoms in the aluminum-containing work function layer.

3. The method for fabricating the semiconductor structure according to claim 1 or 2, wherein at least one of:
- the aluminum-containing work function layer is made of at least one of TiAl, TaAl, TiAlC, TaAlN, TiAlN, and AlN;
- a thickness of the aluminum-containing work function layer is in a range of approximately 30 Å to 70 Å.

4. The method for fabricating the semiconductor structure according to anyone of the claims 1-3, wherein:
the aluminum-containing work function layer is formed by an atomic layer deposition process.

5. The method for fabricating the semiconductor structure according to anyone of the claims 1-4, wherein forming the aluminum-containing work function layer includes:
at least one deposition of an aluminum-containing material, each deposition including:
introducing an aluminum-containing precursor, and
removing the aluminum-containing precursor; and
wherein preferably: the aluminum-containing precursor is one of (C2H5)3Al and AlCH3.

6. The method for fabricating the semiconductor structure according to claim 5, wherein forming the aluminum-containing work function layer includes:
performing multiple times of deposition of the aluminum-containing material, wherein:
a pulse time for introducing the aluminum-containing precursor in each deposition gradually decreases, as the multiple times of deposition of the aluminum-containing material are performed.

7. The method for fabricating the semiconductor structure according to claim 6, wherein:
the pulse time for introducing the aluminum-containing precursor in each deposition is in a range of approximately 8 seconds to 25 seconds.

8. The method for fabricating the semiconductor structure according to anyone of the claims 5-7, wherein forming the aluminum-containing work function layer includes:
performing multiple times of deposition of the aluminum-containing material,
wherein:
a flow rate for introducing the aluminum-containing precursor in each deposition gradually decreases, as the multiple times of deposition of the aluminum-containing material are performed.

9. The method for fabricating the semiconductor structure according to claim 8, wherein:
the flow rate for introducing the aluminum-containing precursor in each deposition is in a range of approximately 200 sccm to 600 sccm.

10. The method for fabricating the semiconductor structure according to anyone of the claims 1-9, wherein the semiconductor structure is a fin field-effect-transistor device, and wherein:
in the process of providing the base structure, the base structure includes a substrate and a plurality of fin structures formed on the substrate;
in the process of forming the plurality of openings, a bottom of each opening exposes a portion of top and sidewall surfaces of a fin structure; and
in the process of forming the gate dielectric layer, the aluminum-containing work function layer, and the metal layer, the gate dielectric layer, the aluminum-containing work function layer, and the metal layer are sequentially formed on a portion of the fin structure exposed in the opening and also on the sidewalls of the opening.

11. A semiconductor structure, comprising:
a base structure;
a dielectric layer formed on the base structure; and
a plurality of gate structures, each including a metal layer formed within the dielectric layer, and an aluminum-containing work function layer together with a gate dielectric layer, formed between the dielectric layer and the metal layer, and between the metal layer and the base structure, wherein,
the aluminum-containing work function layer is formed between the metal layer and the gate dielectric layer, and
along a direction from the gate dielectric layer to the metal layer, an atomic concentration of aluminum atoms in the aluminum-containing work function layer decreases.

12. The semiconductor structure according to claim 11, wherein:
the atomic concentration of the aluminum atoms in the aluminum-containing work function layer is in a range of approximately 40% to 75% by a total number of atoms in the aluminum-containing work function layer; and/or
an average atomic concentration of the aluminum atoms is in a range of approximately 60% to 70% by a total number of atoms in the aluminum-containing work function layer.

13. The semiconductor structure according to claim 11 or 12, wherein:
the aluminum-containing work function layer is made of at least one of TiAl, TaAl, TiAlC, TaAlN, TiAlN, and AIN; and/or
a thickness of the aluminum-containing work function layer is in a range of approximately 30 Å to 70 Å.

14. The semiconductor structure according to anyone of the claims 11-13, wherein the semiconductor structure is a fin field-effect-transistor device, and wherein:
the base structure includes a substrate and a plurality of fin structures formed on the substrate; and
the plurality of gate structures are formed across the fin structures and cover a portion of top and sidewall surfaces of the fin structures.

15. The semiconductor structure according to anyone of the claims 11-14 further including:
an interfacial layer formed between the base structure and each gate dielectric layer.
